(19) Europäisches Patentamt
European Patent Office
Office européen des brevets

(11) **EP 3 215 832 B1**

(12) **EUROPEAN PATENT SPECIFICATION**

(45) Date of publication and mention
of the grant of the patent:
**04.05.2022 Bulletin 2022/18**

(21) Application number: **15805259.7**

(22) Date of filing: **27.10.2015**

(51) International Patent Classification (IPC):
**G01N 27/02** $^{(2006.01)}$     **G01R 31/36** $^{(2020.01)}$
**H01M 8/04** $^{(2016.01)}$

(52) Cooperative Patent Classification (CPC):
**G01N 27/026; G01R 31/367; G01R 31/389;**
**H01M 8/04313; H01M 8/04664; H01M 10/42;**
H01M 2010/4271; Y02E 60/10; Y02E 60/50

(86) International application number:
**PCT/IB2015/058258**

(87) International publication number:
**WO 2016/071801 (12.05.2016 Gazette 2016/19)**

(54) **METHOD AND APPARATUS FOR MONITORING AND DIAGNOSING ELECTROCHEMICAL DEVICES BASED ON AUTOMATIC ELECTROCHEMICAL IMPEDANCE IDENTIFICATION**

VERFAHREN UND VORRICHTUNG ZUR ÜBERWACHUNG UND DIAGNOSE ELEKTROCHEMISCHER GERÄTE BASIEREND AUF EINER AUTOMATISCHEN ERKENNUNG DER ELEKTROCHEMISCHEN IMPEDANZ

PROCEDE ET APPAREIL DE CONTROLE ET DIAGNOSTIC DE DISPOSITIFS ELECTROCHIMIQUES SE BASANT SUR L'IDENTIFICATION AUTOMATIQUE DE L'IMPEDANCE ELECTROCHIMIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **04.11.2014 IT RM20140641**

(43) Date of publication of application:
**13.09.2017 Bulletin 2017/37**

(73) Proprietor: **Universitá Degli Studi Di Salerno**
**84084 Fisciano (SA) (IT)**

(72) Inventors:
• **PETRONE, Raffaele**
**I-84084 Fisciano (SA) (IT)**
• **POLVERINO, Pierpaolo**
**I-84084 Fisciano (SA) (IT)**
• **PIANESE, Cesare**
**I-84084 Fisciano (SA) (IT)**
• **SORRENTINO, Marco**
**I-84084 Fisciano (SA) (IT)**

(74) Representative: **Scilletta, Andrea**
**IP Sextant s.r.l.**
**Via Antonio Salandra, 18**
**00187 Roma (IT)**

(56) References cited:
**US-A1- 2003 184 307**

• **PETRONE R ET AL: "A review on model-based diagnosis methodologies for PEMFCs", INTERNATIONAL JOURNAL OF HYDROGEN ENERGY, ELSEVIER SCIENCE PUBLISHERS B.V., BARKING, GB, vol. 38, no. 17, 25 April 2013 (2013-04-25), pages 7077-7091, XP028543435, ISSN: 0360-3199, DOI: 10.1016/J.IJHYDENE.2013.03.106**
• **WANG K ET AL: "A Review on solid oxide fuel cell models", INTERNATIONAL JOURNAL OF HYDROGEN ENERGY, ELSEVIER SCIENCE PUBLISHERS B.V., BARKING, GB, vol. 36, no. 12, 10 March 2011 (2011-03-10), pages 7212-7228, XP028207829, ISSN: 0360-3199, DOI: 10.1016/J.IJHYDENE.2011.03.051 [retrieved on 2011-03-17]**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

- BETHOUX O ET AL: "A new on-line state-of-health monitoring technique dedicated to PEM fuel cell", IECON 2009 - 35TH ANNUAL CONFERENCE OF IEEE INDUSTRIAL ELECTRONICS (IECON 2009) - 3-5 NOV. 2009 - PORTO, PORTUGAL, IEEE, PISCATAWAY, NJ, USA, 3 November 2009 (2009-11-03), pages 2745-2750, XP031630042, ISBN: 978-1-4244-4648-3
- ESCOBET T ET AL: "Model-based fault diagnosis in PEM fuel cell systems", JOURNAL OF POWER SOURCES, ELSEVIER SA, CH, vol. 192, no. 1, 1 July 2009 (2009-07-01), pages 216-223, XP026122198, ISSN: 0378-7753, DOI: 10.1016/J.JPOWSOUR.2008.12.014 [retrieved on 2008-12-09]
- HISSEL D ET AL: "Diagnosis of automotive fuel cell power generators", JOURNAL OF POWER SOURCES, ELSEVIER SA, CH, vol. 128, no. 2, 5 April 2004 (2004-04-05) , pages 239-246, XP004495014, ISSN: 0378-7753, DOI: 10.1016/J.JPOWSOUR.2003.10.001

## Description

The work leading to this invention, that has been maintained confidential and has not been publicly disclosed so far, has received funding from the European Union's Seventh Framework Programme (FP7/2007-2013) for the Fuel Cells and Hydrogen Joint Technology Initiative under grant agreement n° 256673 (Project D-CODE - DC/DC COnverter-based Diagnostics for PEM systems) and from the University of Salerno.

The present invention relates to a method for monitoring and diagnosis of electrochemical devices to determine their operative state. Such a method is based on an automatic electrochemical impedance identification by exploiting the measurements of the device impedance spectrum in an efficient and reliable way.

Although the presented invention is mainly oriented towards diagnostic applications to determine the operative state of a polymer electrolyte fuel cell (PEFC) system, it may be applied to any other electrochemical device, such as for instance in case of other fuel cells technologies or even batteries, and other applications rather than diagnosis, still remaining within the scope of protection as defined by the attached claims.

Fuel cells are promising systems for the production of electricity due to their load independent high electrical efficiency, their capability to exploit a wide range of fuels and to be easily assembled into a stack to satisfy different power requirements. They can be exploited in a large range of applications, from distributed generation, to residential and industrial cogeneration, and to generation portable and traction. Further, they provide power with lower fuel consumption and exhaust emissions with respect to other technologies. However, they suffer from several problems including the membrane hydration and the degradation of their components, such as the membrane, the electrodes, and the gas diffusion layers, therewith compromising their performance. It is crucial monitoring the state of health of the PEFC while operating. Many solutions have been proposed in the prior art.

As an example, the AVL company has developed a diagnostic tool for the monitoring of PEFC stacks based on voltage drifts analysis (Total Harmonic Distortion Analysis - THDA™), superimposing a signal and evaluating its harmonics. If the arise of extra spectral components (i.e. harmonic distortion) occurs, critical conditions within the stack are detected.

Document US 2003/061182 A1 discloses both a methodology and a system to determine the state of health of a fuel cell. The real part of the fuel cell impedance is measured at specific frequencies, then a fuzzy algorithm infers on the system state-of-health exploiting the measurements of the impedance, the open circuit voltage and the voltage at maximum current.

In document US 2008/042654 A1, a diagnostic device based on magnetic field measurement is disclosed. Through the application of external voltage, a fuel cell stack is forced to generate a magnetic field, which is measured by a dedicated device. This measurement is exploited by a diagnostic device to evaluate the in-plane current distribution and, as a consequence, to characterize the system state. This approach allows the evaluation of the water distribution level within the electrolyte membrane.

Document US 2009/169934 A1 discloses a fuel cell system comprising an impedance measurement device, with the capability of measuring system impedance at low and high frequency regions. These measurements allow the evaluation of the fuel gas supply state and the electrolyte wetting, in order to verify the correct behaviour of the system.

Document US 2005/0287402 A1 discloses the utilization of a voltage ripple superimposed to the fuel cell voltage output to determine the hydration state of a fuel cell stack. This ripple is generated by a voltage inverter and through its application the AC impedance of the stack can be measured. Several measurements are correlated to the fuel cell hydration and can be gathered into a lookup table to provide a baseline for system state estimation.

In document US 2010/0286939 A1, a methodology and a device for the diagnosis of fuel cells deteriorations is disclosed. This device uses a frequency controller to inject current into the fuel cell in order to measure AC impedance. This measurement is then used to detect a deterioration into the fuel cell.

Document US 2007/0172708 A1 discloses a diagnostic system based on the measurement of fuel cell impedance and its use for the determination of equivalent circuit model parameters. These parameters are then related to specific abnormalities within the fuel cell sites. The diagnosis is performed comparing the measured values with values obtained during normal operation.

Document US 2003/184307 A1 discloses a method of determining a state parameter of an electrochemical cell.

Paper of R. Petrone et al. "A review on model-based diagnosis methodologies for PEMFCs", International Journal of Hydrogen Energy, vol. 38, no. 17, 25 April 2013, pp. 7077-7091, discloses some methodology based on models to perform a diagnosis on PEFC systems.

However, prior art solutions suffer from a number of drawbacks. In fact, they are not completely reliable and require complex (and consequently expensive) implementations.

It is an object of this invention, therefore, to provide a monitoring and diagnostic method to evaluate the state of an electrochemical device during its operation in a fully efficient, reliable, simple and inexpensive way.

It is specific subject-matter of the present invention a method for determining the state of an electrochemical device by means of electrochemical impedance spectroscopy (EIS) and equivalent circuit model (ECM) comprising the steps of measuring the system impedance by any EIS device, modelling the measured impedance by an ECM, identifying the ECM parameters through an automatic minimization algorithm, and processing the ECM parameters values to simulate the electrochemical impedance of the device.

In particular, the identifications of the number of parameters (i.e. the ECM model components) and of suitable starting values of these parameters are automatically detected through a geometrical pre-analysis of the shape of the measured impedance spectrum Z', which geometrical pre-analysis will be also called in the following as Geometrical First Guess (GFG) algorithm.

According to a first aspect of the invention, the method for determining the state of an electrochemical device comprises the following steps:

A. measuring the electrochemical device operating conditions gathering information;

B. determining parameters $\beta_0$ on the basis of the measured operating conditions;

C. measuring the impedance spectrum Z' of the electrochemical device by an EIS device;

D. simulating an EIS spectrum $Z_s$ of a Randles ECM having the determined parameters $\beta_0$;

E. computing a first residual indicator $I$ indicating a difference between the measured impedance spectrum Z' and the simulated EIS spectrum $Z_s$ of the Randles ECM;

F. checking whether the first residual vector $I$ is greater than a first predetermined threshold $\varepsilon_1$;

G. if the residual indicator $I$ is lower than the first predetermined threshold $\varepsilon_1$, recognising that the electrochemical device is in a normal operative state and ending the execution of the method;

H. if the residual indicator $I$ is greater than the first predetermined threshold $\varepsilon_1$, starting an automatic identification procedure for identifying a set of parameters $\beta_{id}$ related to the actual operative state of the electrochemical device and a spectrum $Z_{id}$ corresponding to an ECM having parameters $\beta_{id}$, wherein the automatic identification procedure is based on a Geometrical First Guess (GFG) algorithm performing a mathematical minimization algorithm defining a number of parameters to be identified, whereby the ECM components are identified, and starting values of these parameters to be identified, whereby the GFG automatically detects an ECM and selects the starting parameters search space through a geometrical pre-analysis of the measured impedance spectrum Z' shape;

I. computing a second residual indicator $I_{id}$ indicating a difference between the measured impedance spectrum Z' and the spectrum $Z_{id}$ corresponding to the ECM having parameters $\beta_{id}$;

J. checking whether the second residual indicator $I_{id}$ is greater than a second predetermined threshold $\varepsilon_2$;

K. if the residual indicator $I$ is greater than the second predetermined threshold $\varepsilon_2$, recognising that the method execution might be affected by noise and generating an alert;

L. computing a vector residual indicator $I_\beta$, including a set of residuals, indicating a difference between the identified parameters $\beta_{id}$ and the determined parameters $\beta_0$;

M. checking whether the vector residual indicator $I_\beta$ is greater than a set of specific thresholds $\varepsilon_3$, each associated to a respective parameter;

N. if all the residuals of the vector residual indicator $I_\beta$ are lower than the respective thresholds of the set $\varepsilon_3$, recognising that the electrochemical device is near a normal operative state, whereby it is recognised that no fault is occurring in the electrochemical device, and ending the execution of the method;

O. if at least one of the residuals of the vector residual indicator $I_\beta$ is larger than the respective threshold of the set $\varepsilon_3$, matching symptoms representing variable deviations from the normal conditions with the gathered information into a Fault to Symptoms Matrix (FSM); and

P. inferring the operative state of the electrochemical device on the basis of the FSM, whereby at least one specific fault occurring in the electrochemical device is isolated.

According to another aspect of the invention, step H starting an automatic identification procedure for identifying a set of parameters $\beta_{id}$ related to the actual operative state of the electrochemical device and a spectrum $Z_{id}$ corresponding to an ECM having parameters $\beta_{id}$ may comprise the following sub-steps:

H.1 sampling data measured in step C, whereby filtering the points with imaginary part that is positive or close to zero are filtered,

H.2 inputting the filtered sampled data to the Geometrical First Guess (GFG) algorithm,

H.3 inputting the filtered sampled data, the identified ECM components and the identified starting values of the parameters to be identified to a minimization algorithm based on an optimization algorithm,

H.4 computing a goodness of fit of the spectrum $Z_{id}$ corresponding to the ECM having parameters $\beta_{id}$ to the measured impedance spectrum Z',

H.5 checking whether the goodness of fit is sufficient in relation to a fixed reference value,

H.6 if the goodness of fit is sufficient, passing to execute step I,

H.7 if the goodness of fit is not sufficient, modifying the starting values of the parameters to be identified and returning to sub-step H.3.

According to a further aspect of the invention, in sub-step H.3 the minimization algorithm may be a Non Linear Fitting algorithm, optionally a Complex Non-linear Least Square (CNLS), and/or the optimization algorithm may be a Nelder-Mead algorithm.

According to an additional aspect of the invention, in sub-step H.4 the goodness of fit may be computed through a quantity selected from the group comprising a matrix 2-norm corresponding to the percent variation of the spectrum $Z_{id}$ with respect to the measured impedance spectrum Z' and a X-squared coefficient, whereby in sub-step H.5 said quantity is compared with the fixed reference value.

According to another aspect of the invention, in step H.6 the ECM having parameters $\beta_{id}$, and optionally the corresponding spectrum $Z_{id}$, may be saved in a file.

According to a further aspect of the invention, in sub-step H.7 the starting values of the parameters to be identified may be modified randomly within the search space so that the new parameter starting values keep the same order of magnitude of the old parameter starting values.

According to an additional aspect of the invention, the GFG algorithm in step H may comprise the following sub-steps:

H.8 identifying, in a Bode plot of the measured impedance spectrum Z', a maximum value of negative phase which separates high frequencies from the medium/low frequencies, and characterizing the Bode plot by using polynomial regression curves,

H.9 evaluating the derivatives of said polynomial regression curves with respect to the radial frequencies, whereby the anodic and/or diffusion arcs of the Bode plot are detected, so that all the inflection points are identified and thereby the number of arcs is set,

H.10 setting a resistance $R_{\Omega}$ that is extrapolated as the intercept of a first left-side arc of the measured impedance spectrum Z' with the real axis in the Nyquist plane,

H.11 evaluating a cathode charge transfer arc by selecting three points among those lying between the anodic charge transfer arc and the diffusion arc of the Bode plot according to a number of arcs present in the Bode plot, wherein:

- if the anodic charge transfer arc is not present, a point with zero value imaginary part and real part equal to $R_{\Omega}$ is chosen as a first point, corresponding to the first point of the cathode charge transfer arc,
- if the charge transfer anodic arc is present, the first point is chosen among the filtered sampled data as the last one belonging to the anodic charge transfer arc, wherein the information about how many sampled measured points belong to each arc is obtained in sub-step H.9 through the Bode plot considering the inflection points,
- if the diffusion arc is not present, the second point is chosen as a second interception of the measured impedance spectrum Z' with the real axis,
- if the diffusion arc is present, the second point is chosen in the range of an inflection point, optionally three or four points before the inflection point,
- the third point is chosen as a mean point among the first and the second points,
- a circumference is achieved by interpolation of said three points, and coordinates of its centre and of its first and second intercepts with the real axis are computed, whereby if the anodic arc is not present the first intercept corresponds to the first point,

H.12 if the anodic charge transfer arc is present, computing anode parameters so that an anodic charge transfer resistance $R_{ct,a}$ is computed as a difference between the first intercept of said circumference and the value obtained for resistance $R_{\Omega}$, and a capacitor $C_{dl}$ is computed as follows:

$$C_{dl} = \frac{1}{R_{ct,a}\omega_A}$$

where $\omega_A$ is a radial frequency of a maximum negative imaginary part of the anode arc, whereby it is the point with real part equal to $(R_{\Omega} + R_{ct,a}/2)$,

H.13 computing cathode parameters so that a cathode charge transfer resistance $R_{ct,c}$ is obtained as a difference between the second intercept and the first intercept, and an element *CPE* representing a Constant Phase Element is characterised by considering an equivalent capacitor as follows:

$$C_{eq,c} = \frac{1}{R_{ct,c}\omega_C}$$

where $\omega_C$ is a radial frequency of a maximum negative imaginary part of the cathode arc, assumed as the radial frequency corresponding to the point with real part equal to $(R_\Omega + R_{ct,a} + R_{ct,c}/2)$, whereby the element *CPE* can be modelled through two parameters, *Q* and $\phi$, as follows:

$$Z_{CPE} = \frac{1}{Q(j\omega)^\phi}$$

$$Q = C_{eq,c}\omega_C^{1-\phi}$$

$$\phi = 1 - \frac{2\alpha}{\pi}$$

where $\alpha$ is an angle defined by the real axis and a radius of the cathode charge transfer arc,

H.14 if the diffusion arc is present, computing a Warburg element *Zw* as depending on parameters $R_d$ and $\tau_d$ as follows:

$$Z_W = R_d \frac{tanh(\sqrt{j\omega\tau_d})}{\sqrt{j\omega\tau_d}}$$

where diffusion resistance $R_d$ is computed as a difference between the second intercept of the Bode plot of the measured impedance spectrum Z' with the real axis and the second intercept of said circumference with the real axis, whereby Warburg time constant $\tau_d$ is equal to

$$\tau_d = \omega_D^{-0.5}$$

where $\omega_D$ is a radial frequency related to a maximum negative imaginary part of the diffusion arc, corresponding to the point with real part equal to

$$(R_\Omega + R_{ct,a} + R_{ct,c} + R_d/2),$$

H.15 outputting vector $\beta = [R_\Omega, R_{ct,a}, C_{dl}, R_{ct,c}, Q, \phi, Rd, \tau_d]$ to sub-step H.3, optionally saving vector 6 in a file.

According to another aspect of the invention, the first residual vector *I* may be computed in step E through a matrix 2-norm of the measured impedance spectrum Z' and the EIS spectrum $Z_s$ of the Randles ECM having the determined parameters $\beta_0$ as follows:

$$I = \frac{\|Z' - Z_s\|_2}{\|Z_s\|_2}$$

and the second residual indicator $I_{id}$ may be computed in step I through a matrix 2-norm of the measured impedance spectrum Z' and the spectrum $Z_{id}$ corresponding to the ECM having parameters $\beta_{id}$ as follows:

$$I_{id} = \frac{\|Z' - Z_{id}\|_2}{\|Z_{id}\|_2}$$

According to a further aspect of the invention, the vector residual indicator $I_\beta$ may be computed in step L as normalized difference between the identified parameter $\beta_{id}$ and the determined parameters $\beta_0$ as follows:

$$I_\beta = \frac{\beta_{id} - \beta_0}{\beta_0}$$

According to an additional aspect of the invention, the electrochemical device may comprise a polymer electrolyte fuel cell (PEFC) system.

It is another specific subject-matter of the present invention an apparatus for determining the state of an electrochemical device as claimed in independent claim 11.

The present invention will be now described, by way of illustration and not by way of limitation, according to its preferred embodiments, by particularly referring to the Figures of the annexed drawings, in which:

Fig. 1 is a schematic block diagram of the configuration used for EIS measurements of a fuel cell system connected to an electronic load performed in a preferred embodiment of the method for determining the state of an electrochemical device according to the invention, wherein the electrochemical device is a fuel cell;

Figs. 2A and 2B are circuit diagrams of ECMs representative of a generic fuel cell, wherein the first circuit diagram shown in FIG. 2A is a complete ECM, modelling the main physical phenomena occurring in a fuel cell, whereas the second circuit diagram shown in Fig. 2B is the Randles model;

Fig. 3 is a flow chart of the algorithm performed by the preferred embodiment of the method for determining the state of an electrochemical device according to the invention, wherein the electrochemical device is a fuel cell;

Fig. 4 is a flow chart of an identification algorithm for the identification of the ECM parameters values performed by the method of Fig. 3;

Figs. 5A, 5B, 5C and 5D represent four ECM configurations each associated with a respective corresponding EIS spectrum shape, in accordance with the physical phenomena (i.e. charge transfer and diffusion) generally occurring in a common PEFC system;

Fig. 6 is a flow chart representing the procedure followed by the Geometrical First Guess (GFG) algorithm performed by the method of Fig. 3;

Fig. 7a shows the Bode plot of an EIS spectrum, while Fig, 7b shows the Nyquist graph of the same EIS spectrum wherein the number of the characteristic arcs of the spectrum can be identified; in particular, the graphs of Fig. 7 are based on a data set available in the open literature and published by Fouquet et al. in J. Power Sources, 159 (2006), pp. 905-913, related to a PEFC in which the anodic side effect is negligible, i.e. wherein the Nyquist graph does not exhibit the anodic charge transfer arc;

Fig. 8 is the Nyquist graph of the Fig. 7b plotted over a different (larger) scale and it is a graphic example of some geometric shapes and features identified by the GFG algorithm of Fig.6 on the EIS spectrum of Fig. 7b; and

Fig. 9 is a schematic block diagram of a configuration of the diagnostic algorithm with respect to a fuel cell system and the EIS measurement device required for an online monitoring and diagnosis according to the method of Fig. 3.

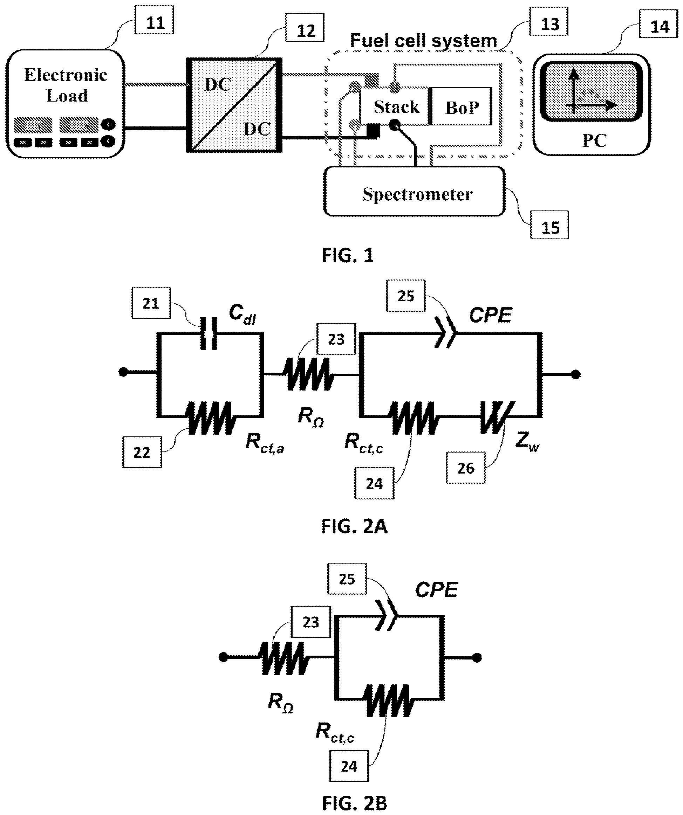

Referring to Fig. 1, in order to measure an EIS spectrum on a generic PEFC system 13, comprising a stack of a fuel cell and other sub-systems and components (the so called Balance of Plant, BoP), connected to an electronic load 11 through a DC/DC converter 12, a spectrometer 15 is required. This spectrometer is able to measure the impedance $Z$ of the whole system by measuring the current, drawn by the electronic load, and the voltage by means of four cables directly connected to the PEFC system 13 terminals. A controller unit 14, such as a Personal Computer (PC), controls the spectrometer 15 and displays the measured spectrum.

Fig. 2A shows the ECM representing a generic PEFC system, each element being directly or indirectly related to a specific physical phenomenon characteristic of the PEFC. The left part of the ECM, including the capacitor $C_{dl}$ 21 connected in parallel to the resistance $R_{ct,a}$ 22, represents the anode electrode behaviour. Particularly, the resistance $R_{ct,a}$ 22 models the charge transfer resistance at the anode side, whereas the capacitor $C_{dl}$ 21 models the charge double layer phenomenon. The element $R_\Omega$ 23 represents the resistance of the electrolyte. The resistance $R_{ct,c}$ 24 models the charge transfer resistance at cathode side. The element $CPE$ 25 represents the Constant Phase Element (CPE), which models the charge double layer phenomenon in case of rough irregular surfaces (e.g. pores). The last element Zw 26 models the Warburg impedance, which is related to the diffusion processes at cathode side. In particular, the resistance $R_{ct,c}$ 24 is connected in series to the element Zw 26, thus forming a branch connected in parallel to the element $CPE$ 25 and in series to the element $R_\Omega$ 23, that in turn is connected in series to the parallel circuit including the capacitor $C_{dl}$ 21 and the resistance $R_{ct,a}$ 22. Generally, when no phenomenon can be neglected, the aforementioned ECM is used to represent the impedance of a PEFC. However, when the influence of the anode behaviour and the cathode diffusion phenomenon can be neglected (i.e. only one arc is clearly visible in the EIS spectrum), the simple Randles ECM can be used. This circuit includes only the resistance $R_\Omega$ 23 connected in series to the parallel circuit including the resistance $R_{ct,c}$ 24 and the element $CPE$ 25, as shown in Fig. 2B.

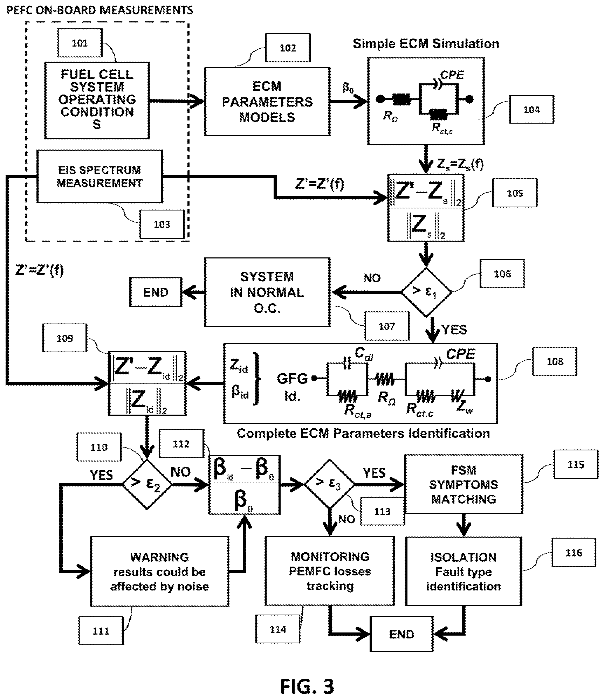

Fig. 3 shows the flow chart of a preferred embodiment of the method for determining the state of an electrochemical device wherein the electrochemical device is a PEFC system. Advantageously, the method is executed automatically. Considering the system in a steady-state, in a step 101 the PEFC system operating conditions, such as fuel cell (FC) temperature and drawn current, are taken as inputs to evaluate (i.e. to determine) the ECM parameter models $\beta_0$ at step 102. Such parameter models $\beta_0$ are predetermined values related to (i.e. depending on) the operating conditions. These models are characterized by empirical expressions derived by experimental data (e.g. analytical functions of temperature and current). In other embodiments of the present invention, the parameter models can be represented by matrices with predetermined values.

In step 103, that is executed in parallel to step 101, the EIS spectrum $Z'$ measurement is performed by the EIS board; in particular, as known to those skilled in the art, a spectrum is a function of frequency (e.g. $Z' = Z'(f)$). Then, in step 104 part of the parameters $\beta_0$ are exploited into the simple Randles ECM (i.e., the Randles ECM has the parameters $\beta_0$) to simulate the EIS spectrum $Z_s$ at the considered operating conditions. Once the two spectra $Z_s$ and $Z'$ are obtained, a first residual indicator $I$ is computed in step 105 through the matrix 2-norm as:

$$I = \frac{\|Z' - Z_s\|_2}{\|Z_s\|_2} \qquad [\text{Eq. 1}]$$

In other embodiments of the method according to the invention, the first residual indicator $I$ that indicates the difference between the two spectra $Z'$ and $Z_s$ may be computed through a criterion different from the matrix 2-norm, such as the X-squared coefficient, still remaining within the scope of the invention.

In step 106, it is checked whether the first residual indicator $I$ is greater than a first predetermined threshold $\varepsilon_1$. If the first residual indicator $I$ is lower than or equal to the first predetermined threshold $\varepsilon_1$, the flow continues through the "NO" branch from step 106, whereby the method according to the invention recognises (step 107) that the PEFC system is running under normal conditions, i.e. it is in a normal operative state (namely, no malfunction is occurring), and the method ends (or return to step 101).

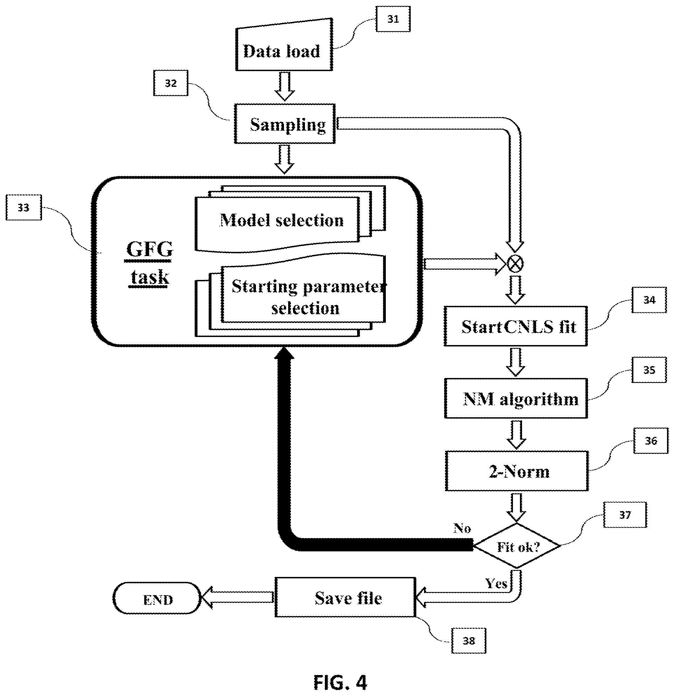

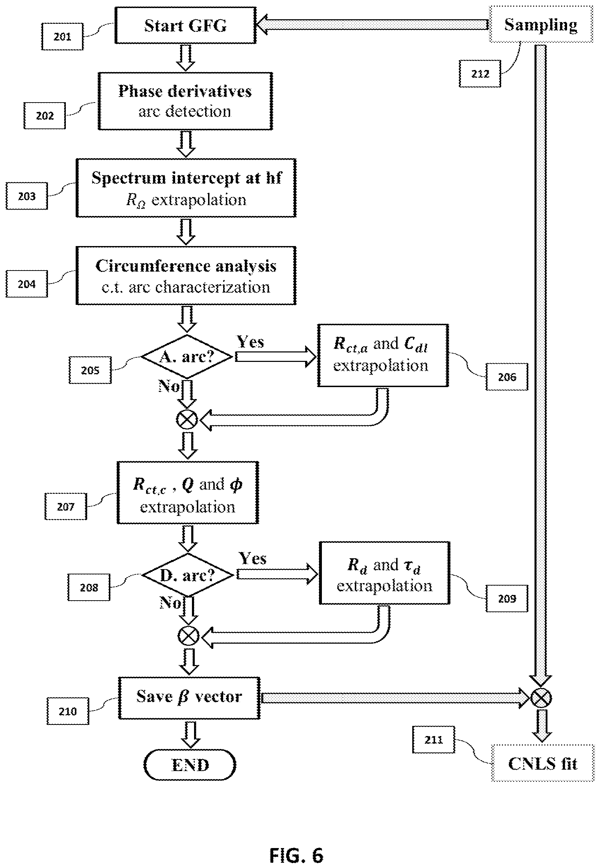

Alternatively, if the first residual indicator $I$ is greater than the first predetermined threshold $\varepsilon_1$, the flow continues through the "YES" branch from step 106, whereby the method according to the invention recognises that an unexpected event is occurring in the system and an identification procedure starts in step 108. This procedure, with reference to Figs. 4 and 6, is implemented by means of the ECM shown in Fig. 2A and it will be described in detail below. Such procedure is based on a Geometrical First Guess algorithm (GFG) for identification of a set of parameters $\beta_{id}$), related to the actual operative state, and of the spectrum $Z_{id}$ (corresponding to the ECM having parameters $\beta_{id}$). The latter is compared to the measured spectrum $Z'$, thus computing the matrix 2-norm second residual indicator $I_{id}$ in step 109:

$$I_{id} = \frac{\|Z' - Z_{id}\|_2}{\|Z_{id}\|_2} \qquad [\text{Eq.2}]$$

In other embodiments of the method according to the invention, the second residual indicator $I_{id}$ that indicates the difference between the two spectra $Z'$ and $Z_{id}$ may be computed through a criterion different from the matrix 2-norm, such as the X-squared coefficient, still remaining within the scope of the invention. Also in this case, in step 110 it is checked whether the second residual indicator $I_{id}$ is greater than a second predetermined threshold $\varepsilon_2$. If the residual indicator $I_{id}$ computed through Eq. 2 is lower than or equal to the second predetermined threshold $\varepsilon_2$, the flow continues through the "NO" branch from step 110, and the vector residual indicator $I_\beta$, including a set of residuals, is computed in step 112 as normalized difference between the identified parameter $\beta_{id}$ and the reference ones $\beta_0$ evaluated in step 101:

$$I_\beta = \frac{\beta_{id} - \beta_0}{\beta_0} \qquad [\text{Eq.3}]$$

In other embodiments of the method according to the invention, the vector residual indicator $I_\beta$ that indicates the difference between the identified parameters $\beta_{id}$ and the reference ones $\beta_0$ may be computed through a criterion different from the normalized difference, such as the mean square error (MSE), still remaining within the scope of the invention. If the residual indicator computed through Eq. 2 is higher than the second predetermined threshold $\varepsilon_2$, the flow continues through the "YES" branch from step 110, whereby the method according to the invention recognises that the results might be affected by noise, and an alert is generated in step 111 before executing step 112 computing the vector residual indicator $I_\beta$ according to Eq. 3.

The analysis of the computed vector residual indicator $I_\beta$ is performed defining a set of specific thresholds $\varepsilon_3$,

each associated to a respective parameter and making a check in step 113: if all the residuals of the vector residual indicator $I_\beta$ lie within the respective defined threshold ranges (i.e. are lower than the respective threshold of the set $\varepsilon_3$), the flow continues through the "NO" branch from step 113, wherein the method according to the invention recognises that the system is considered still near the normal operating condition. In such a case, the algorithm performed by the method according to the invention recognises that no fault is occurring in the system and one or more main losses are monitored in step 114. This step allows the method according to the invention to follow the system behaviour in terms of performance reduction. If at least one residual overcomes the respective threshold, the flow continues through the "YES" branch from step 113, whereby the method according to the invention recognises that an analytical symptom arises. This symptom consists in a binary number which represents the occurrence of a variable deviation from the normal conditions. A further analysis of the gathered information by means of a Fault to Symptoms Matrix (FSM) is made in step 115. A FSM is a matrix correlating a specific fault with the main variables affected by this fault. In this matrix, the faults are listed in the rows whereas the variables (i.e. symptoms) are listed in the columns. In the corresponding cell location a "1" (one) is present if a symptom is related to a specific fault, whereas a "0" (zero) if not. By matching the obtained symptoms with the information gathered into the FSM, an inference on the system state is made and at least one specific fault occurring in the system can be isolated in step 116.

Other embodiments of the method according to the invention may have the flow that continues through the "YES" branch from steps 106, 110 and 113 when the first residual indicator $I$, the second residual indicator $I_{id}$ and the residual vector $I_\beta$, respectively, are not lower (instead of larger) than the first predetermined threshold $\varepsilon_1$, the second predetermined threshold $\varepsilon_2$ and the set of specific thresholds $\varepsilon_3$ (in other words, in these embodiments the equality between an indicator and the respective threshold causes the flow to follow the "YES" branch), still remaining within the scope of the invention.

The identification procedure performed in step 108 allows the method according to the invention to achieve a reliable diagnosis of the system state. This procedure is based on a mathematical minimization algorithm which requires the definition of: i) the number of parameters to be identified (i.e. the ECM model components), and ii) the suitable starting values of these parameters. The GFG algorithm satisfies these two requirements. The GFG is capable to automatically detect the suitable ECM configuration and to select its proper starting parameters search space through a geometrical pre-analysis of the measured impedance spectrum $Z'$ shape.

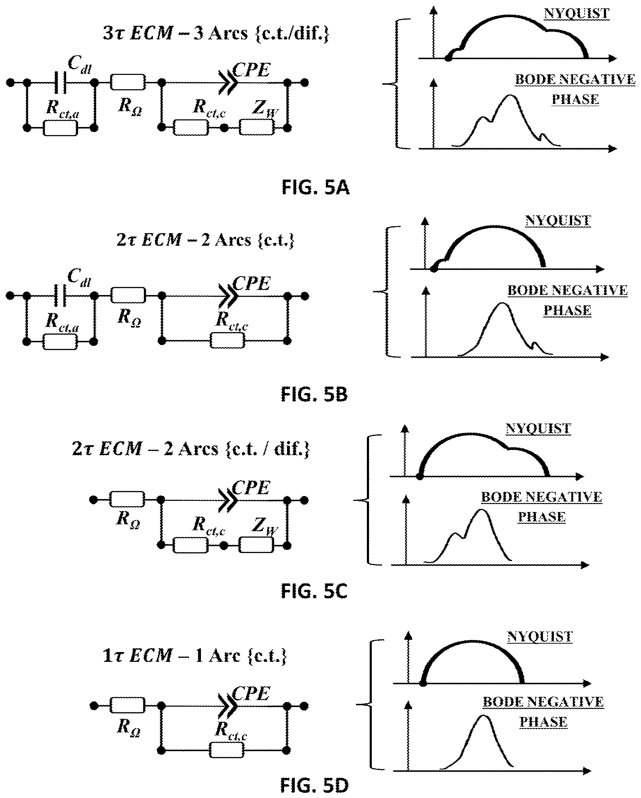

Fig. 4 shows a flow chart of an automatic identification algorithm for the identification of the ECM parameter values implemented by the method according to the invention in step 108 of Fig. 3. The first step 31 of this identification algorithm consists in acquiring the data measured by the EIS board (hence, it could also be coincident with step 103). Then, a data sampling is implemented on the frequencies in step 32. The sampling filters (i.e. deletes) the points with an imaginary part that is positive or close to zero (e.g. $<10^{-3}\,\Omega$), because these points can hinder reaching the convergence of the minimization procedure. The sampled data output are input to the GFG algorithm that starts in step 33, extrapolating the suitable ECM configuration and the parameter initial conditions. The GFG algorithm will be described later in detail with reference to the flow-chart depicted in Fig.6 associated to the ECM configurations sketched in Figs. 5A-5D. The sampled data and the detected suitable ECM configuration and parameters initial conditions outputs are input to a minimization algorithm (e.g. Complex Non-linear Least Square - CNLS - or another Non Linear Fitting algorithm) that is executed in step 34. The optimization algorithm, on which the minimization algorithm is based, can be assumed for example being the Nelder-Mead algorithm (step 35). In step 36, the goodness of fit is computed through a matrix 2-norm corresponding to the percent variation of the identified spectrum with respect to the measured one. Then, in step 37, it is checked whether the matrix 2-norm is less than a fixed reference value. If the matrix 2-norm is less than such fixed value, the flow continues through the "YES" branch from step 37, whereby the identification algorithm recognises that the fit quality is good, and the results are both input to step 109 of the algorithm shown in Fig. 3 (though this is not shown in Fig. 4) and saved in a file in the step 38 (shown in Fig. 4) before the procedure ends. If the matrix 2-norm exceeds or is equal to this fixed value level, the flow continues through the "NO" branch from step 37, and the starting parameters extrapolated by the GFG in step 33 are modified and the CNLS procedure starts again (step 34). The starting parameters modification is made randomly, although within a search space where the new parameter starting values keep the same order of magnitude of the old ones. Other embodiments of the present invention may use criterions for checking goodness of fit criterion different from the matrix 2-norm, such as the X-squared coefficient, as well as modifications of the starting values of the parameters different from the random modification, still remaining within the scope of the invention.

Figs. 5A, 5B, 5C and 5D show all the possible ECM configurations, which are considered into the GFG algorithm modelling the PEFC behaviour. The complete ECM modelling a PEFC behaviour is shown in Fig. 5A. This ECM shows three time constants $\tau$ associated to three arcs in the Nyquist plot of the related impedance spectrum. These arcs refers to the main phenomena occurring into the PEFC. The first arc on the left of the Nyquist plot refers to the charge transfer occurring at the anode side; the middle arc is related to the charge transfer at the cathode side; the last arc, on the right, corresponds to the diffusion. Nevertheless, the PEFC cell physical phenomena might overlap and the number of the observable arcs of the related Nyquist plot of impedance spectrum reduces. For this reason, the corresponding ECM is simplified: on the one hand, the Warburg element $Zw$ can be neglected (as shown in Fig. 5B) as the PEFC cell diffusion phenomenon is neglected; on the other hand, when the diffusion phenomenon must be taken into account rather than the anode side effects in PEFC cell, the corresponding ECM is reshaped as shown in Fig. 5C. These two last ECMs show both only two time constants $\tau$ associated to two arcs in the related Nyquist plot of impedance. The last ECM shown in Fig 5D is the Randles ECM having only one time constant $\tau$ associated to one arc in the related Nyquist plot of impedance, which corresponds to the charge transfer losses at cathode side. It is worth noting that when a change in the number of the arcs of the Nyquist plot occurs, its related Bode phase is also affected. For this reason, through the analysis of the first and the second derivatives of the Bode negative phase, it is possible to detect a change in the impedance shape.

The GFG algorithm automatically choose among these ECMs just analysing specific features of the measured EIS spectrum of PEFC. If a physical phenomenon is negligible or absent, the GFG algorithm sets to zero the related parameters and the procedure removes them from the identification. The ECM configuration for the fit becomes one of those shown in Figs. 5A, 5B, 5C and 5D. When the proper ECM is chosen, a geometric analysis is performed to set the initial values of the parameters to be identified.

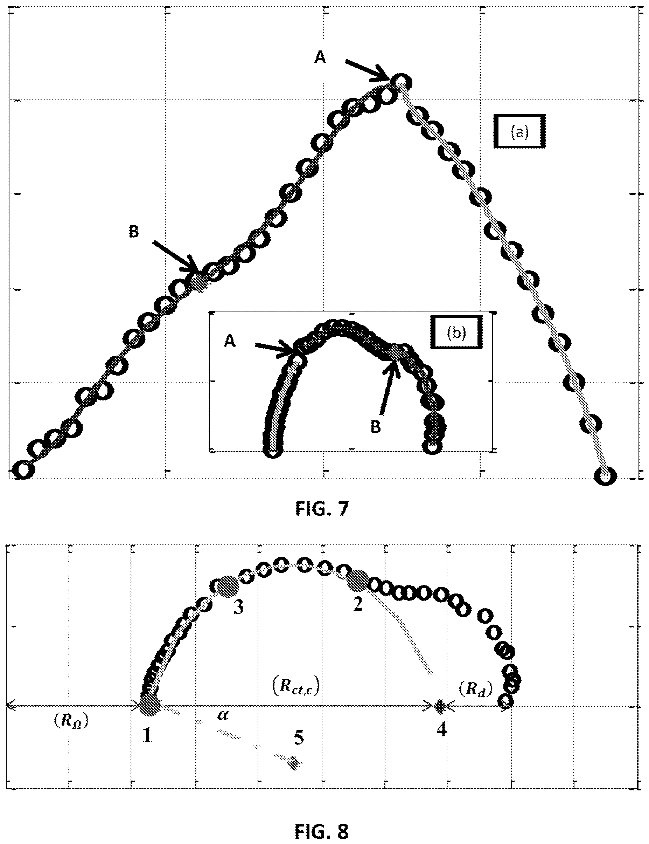

In Fig. 6, the flow chart representing the steps executed by the GFG algorithm is shown. The Sampling step 212 and the CNLS fit step 211 corresponds to steps 32 and 34 shown in Fig. 4, respectively. Also referring to the spectra shown in Fig. 7, in step 201 the GFG algorithm starts: the GFG algorithm identifies the maximum value of the Bode plot negative phase (Point A in Fig. 7), which separates the high frequencies from the medium/low ones; then, polynomial regression curves are used to characterize the Bode plot at medium/low and high frequencies. Step 202 performs the evaluation of the derivatives of these polynomials with respect to the radial frequencies allowing the detection of the anodic and/or diffusion arcs. Once all the inflection points are identified (such as point B in Fig. 7), the number of arcs is set. Thus, the suitable ECM configuration is selected and the initial values of its parameters can be found through the parameters evaluation procedure (steps 203 through 209) described below also with reference to Fig. 8. The first parameter set is the resistance $R_\Omega$, extrapolated as the intercept of the first arc with the real axis in the Nyquist plane in step 203 (see Fig. 8, point 1 at the left side of the plot). The evaluation of the cathode charge transfer arc (step 204) is performed analysing the information gathered in the Nyquist graph. Three points 1, 2 and 3 (shown in Fig. 8) are selected according to the number of arcs present in the Bode graph. These points are chosen among those lying between the anodic charge transfer arc and the diffusion arc. If the anodic charge transfer arc is not present, the point with zero value imaginary part and real part equal to $R_\Omega$ is chosen as the first point 1, corresponding to the first point of the cathode charge transfer arc. If the charge transfer anodic arc is present, the first point 1 is chosen among the sampled data as the last one belonging to the aforementioned anodic charge transfer arc. The information about how many sampled measured points belong to each arc is obtained in step 202 through the Bode plot considering the inflection points. If the diffusion arc is not present, the second point 2 is chosen as the second interception of the sampled measured spectrum Z' with the real axis. Differently, if the diffusion arc is present, the second point 2 is chosen in the range of point B (shown in Fig. 7), e.g. three or four points before (as shown in Fig. 8). The third point 3 is chosen as the mean point among the first and the second point 1 and 2 respectively. A circumference is then achieved by interpolation of the aforementioned points and taking into account also the sampled measured ones laying among these points, so as to avoid any abnormal deviation of the measurements. Thus, once the circumference is obtained, the coordinates of its centre 5 and of its first and second intercepts 6, 4, respectively, with the real axis are computed. If the anodic arc is not present the first intercept 6 corresponds to the first point 1 as shown in Fig. 8.

Step 205 in Fig. 6 considers the presence of the anodic charge transfer arc. If the anodic charge transfer arc is present, the flow continues through the branch "Yes" from step 205, and the anode parameters are computed in block 206. The anodic charge transfer resistance $R_{ct,a}$ is computed as the difference between the first intercept 6 of the semicircle and the value obtained for $R_\Omega$. Then, the capacitor $C_{dl}$ is evaluated as follows:

$$C_{dl} = \frac{1}{R_{ct,a}\omega_A} \qquad \text{[Eq.4]}$$

where $\omega_A$ is the radial frequency of the maximum negative imaginary part of the anode arc, or, in other words, the point with real part equal to $(R_\Omega + R_{ct,a}/2)$. If the anodic arc is not present, the flow continues through the branch "No", and the algorithm directly computes the cathode parameters in step 207 that is described below. The cathode charge transfer resistance $R_{ct,c}$ is obtained as the difference between the second intercept 4 and the first intercept 6. These points have only real part (i.e. imaginary part equal to zero). In order to characterize the *CPE*, an equivalent capacitor is considered:

$$C_{eq,c} = \frac{1}{R_{ct,c}\omega_C} \qquad \text{[Eq.5]}$$

where $\omega_C$ is the radial frequency of the maximum negative imaginary part of the cathode arc, assumed as the radial frequency corresponding to the point with real part equal to $(R_\Omega + R_{ct,a} + R_{ct,c}/2)$. The element *CPE* can be then modelled through two parameters, $Q$ and $\phi$, as follows:

$$Z_{CPE} = \frac{1}{Q(j\omega)^\phi} \qquad [\text{Eq.6}]$$

$$Q = C_{eq,c} \omega_C^{1-\phi} \qquad [\text{Eq.7}]$$

$$\phi = 1 - \frac{2\alpha}{\pi} \qquad [\text{Eq.8}]$$

where $\alpha$ is the angle defined by the real axis and the radius of the cathode charge transfer arc (shown as dashed segment between point 1 and point 5 in Fig. 8). The last element to be computed is the Warburg element Zw. This element is related to the diffusion phenomenon, and it is introduced in the ECM only if the diffusion arc is present, whereby the flow continues through the branch "Yes" from step 208 and the diffusion parameters are computed in block 209. The Zw expression depends on the parameters $R_d$ and $\tau_d$ as follows:

$$Z_W = R_d \frac{tanh(\sqrt{j\omega\tau_d})}{\sqrt{j\omega\tau_d}} \qquad [\text{Eq.9}]$$

where the parameter $R_d$ is the diffusion resistance and it is evaluated as the difference between the second interception of the whole sampled measured spectrum with the real axis and the point 4, as shown in Fig. 8. The parameter $\tau_d$ is the Warburg time constant, expressed as

$$\tau_d = \omega_D^{-0.5} \qquad [\text{Eq.10}]$$

where $\omega_D$ is the radial frequency related to the maximum negative imaginary part of the diffusion arc, corresponding to the point with real part equal to

$$(R_\Omega + R_{ct,a} + R_{ct,c} + R_d/2).$$

When all the parameters are extrapolated, the GFG algorithm (step 210) outputs the vector $\beta = [R_\Omega, R_{ct,a}, C_{dl}, R_{ct,c}, Q, \phi, R_d, \tau_d]$ to step 34 of Fig. 4 and saves it, and the GFG algorithm ends.

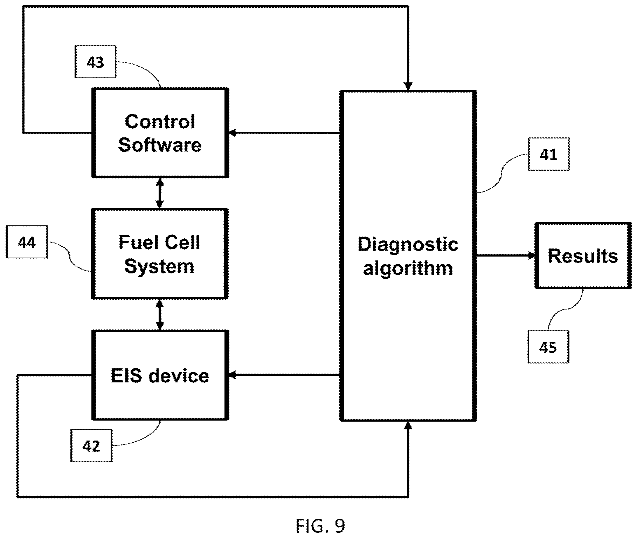

In Fig. 9 a schematic block diagram of a configuration of the method 41 for determining the state of an electrochemical device according to the invention wherein the electrochemical device is a generic fuel cell system 44 and an EIS measurement device 42 according to a preferred embodiment is given. In this block diagram, the method 41 communicates with the EIS device 42 and the system control software 43 to send and receive information (e.g. operating conditions such as FC temperature and drawn currents ,measured EIS spectra, FC state evaluation). The EIS board 42 and the system control software 43 measures the data on the system 44. When the EIS measurement is completed, the EIS board 42 sends a feedback to the method 41 to allow the evaluation of the system state, and the information can be exploited by the system control software 43 to avoid dangerous operations; also, the results 45 obtained by the method 41 may be transmitted or displayed to an operator.

It must be understood that Fig. 9 may be also construed as showing a schematic block diagram of a configuration including the preferred embodiment of an apparatus including processing means (e.g. a personal computer) executing the method for determining the state of an electrochemical device according to the invention, wherein block 41 represents such apparatus, provided with a display (or communication unit) 45, that communicates with an interface 43 of the system controlling the fuel cell system 44 and with the EIS device 42. Possibly, other embodiments of the apparatus according to the invention may be incorporated into the system controlling the fuel cell system 44, whereby the apparatus executes both the system control software and the method for monitoring and diagnosis of an electrochemical device according to the invention.

The preferred embodiments of this invention have been described, but it should be understood that those skilled in the art can make other variations and changes, without so departing from the scope of protection thereof, as defined by the attached claims.

**Claims**

1. Method for determining the state of an electrochemical device based on an automatic electrochemical impedance identification, the method comprising the following steps:

    A. measuring (101) the electrochemical device operating conditions gathering information;
    B. determining (102) parameters $\beta_0$, of a Randles equivalent circuit model (ECM) on the basis of the measured operating conditions;
    C. measuring (103) the impedance spectrum Z' of the electrochemical device by an electrochemical impedance spectroscopy (EIS) device;
    D. simulating (104) an EIS spectrum $Z_s$ of the Randles ECM having the determined parameters $\beta_0$;
    E. computing (105) a first residual indicator $I$ indicating a difference between the measured impedance spectrum Z' and the simulated EIS spectrum $Z_s$ of the Randles ECM;
    F. checking (106) whether the first residual vector $I$ is greater than a first predetermined threshold $\varepsilon_1$;
    G. if the residual indicator $I$ is lower than the first predetermined threshold $\varepsilon_1$, recognising that the electrochemical device is in a normal operative state and ending the execution of the method;
    H. if the residual indicator $I$ is greater than the first predetermined threshold $\varepsilon_1$, starting (108) an automatic identification procedure for identifying a set of parameters $\beta_{id}$ related to the actual operative state of the electrochemical device and a spectrum $Z_{id}$ corresponding to an ECM having parameters $\beta_{id}$, wherein the automatic identification procedure is based on a Geometrical First Guess (GFG) algorithm performing a mathematical minimization algorithm defining a number of parameters to be identified, whereby the ECM components are identified, and starting values of these parameters to be identified, whereby the GFG automatically detects an ECM and selects the starting parameters search space through a geometrical pre-analysis of the measured impedance spectrum Z' shape;
    I. computing (109) a second residual indicator $I_{id}$ indicating a difference between the measured impedance spectrum Z' and the spectrum $Z_{id}$ corresponding to the ECM having parameters $\beta_{id}$;
    J. checking (110) whether the second residual indicator $I_{id}$ is greater than a second predetermined threshold $\varepsilon_2$;
    K. if the residual indicator $I$ is greater than the second predetermined threshold $\varepsilon_2$, recognising that the method execution might be affected by noise and generating (111) an alert;
    L. computing (112) a vector residual indicator $I_\beta$, including a set of residuals, indicating a difference between the identified parameters $\beta_{id}$ and the determined parameters $\beta_0$;
    M. checking (113) whether the vector residual indicator $I_\beta$ is greater than a set of specific thresholds $\varepsilon_3$, each associated to a respective parameter;
    N. if all the residuals of the vector residual indicator $I_\beta$ are lower than the respective thresholds of the set $\varepsilon_3$, recognising (114) that the electrochemical device is near a normal operative state, whereby it is recognised that no fault is occurring in the electrochemical device, and ending the execution of the method;
    O. if at least one of the residuals of the vector residual indicator $I_\beta$ is larger than the respective threshold of the set $\varepsilon_3$, matching (115) symptoms representing variable deviations from the normal conditions with the gathered information into a Fault to Symptoms Matrix (FSM); and
    P. inferring (116) the operative state of the electrochemical device on the basis of the FSM, whereby at least one specific fault occurring in the electrochemical device is isolated.

2. Method according to claim 1, wherein step H starting (108) an automatic identification procedure for identifying a set of parameters $\beta_{id}$ related to the actual operative state of the electrochemical device and a spectrum $Z_{id}$ corresponding to an ECM having parameters $\beta_{id}$ comprises the following sub-steps:

    H.1 sampling (32) data measured in step C, whereby filtering the points with imaginary part that is positive or close to zero are filtered,
    H.2 inputting (33) the filtered sampled data to the Geometrical First Guess (GFG) algorithm,
    H.3 inputting (34) the filtered sampled data, the identified ECM components and the identified starting values of the parameters to be identified to a minimization algorithm based on an optimization algorithm (35),
    H.4 computing (36) a goodness of fit of the spectrum $Z_{id}$ corresponding to the ECM having parameters $\beta_{id}$ to the measured impedance spectrum Z',
    H.5 checking (37) whether the goodness of fit is sufficient in relation to a fixed reference value,

H.6 if the goodness of fit is sufficient, passing to execute step I,
H.7 if the goodness of fit is not sufficient, modifying the starting values of the parameters to be identified and returning to sub-step H.3.

3. Method according to claim 2, wherein in sub-step H.3 the minimization algorithm is a Non Linear Fitting algorithm, optionally a Complex Non-linear Least Square (CNLS), and/or the optimization algorithm is a Nelder-Mead algorithm.

4. Method according to claim 2 or 3, wherein in sub-step H.4 the goodness of fit is computed through a quantity selected from the group comprising a matrix 2-norm corresponding to the percent variation of the spectrum $Z_{id}$ with respect to the measured impedance spectrum $Z'$ and a X-squared coefficient, whereby in sub-step H.5 said quantity is compared with the fixed reference value.

5. Method according to any one of claims 2 to 4, wherein in step H.6 the ECM having parameters $\beta_{id}$, and optionally the corresponding spectrum $Z_{id}$, are saved (38) in a file.

6. Method according to any one of claims 2 to 5, wherein in sub-step H.7 the starting values of the parameters to be identified are modified randomly within the search space so that the new parameter starting values keep the same order of magnitude of the old parameter starting values.

7. Method according to any one of claims 2 to 6, wherein the GFG algorithm in step H comprises the following sub-steps:

H.8 identifying (201), in a Bode plot of the measured impedance spectrum $Z'$, a maximum value of negative phase which separates high frequencies from the medium/low frequencies, and characterizing the Bode plot by using polynomial regression curves,
H.9 evaluating (202) the derivatives of said polynomial regression curves with respect to the radial frequencies, whereby the anodic and/or diffusion arcs of the Bode plot are detected, so that all the inflection points are identified and thereby the number of arcs is set,
H.10 setting (203) a resistance $R_{\Omega}$ that is extrapolated as the intercept of a first left-side arc of the measured impedance spectrum $Z'$ with the real axis in the Nyquist plane,
H.11 evaluating (204) a cathode charge transfer arc by selecting three points among those lying between the anodic charge transfer arc and the diffusion arc of the Bode plot according to a number of arcs present in the Bode plot, wherein:

- if the anodic charge transfer arc is not present, a point with zero value imaginary part and real part equal to $R_{\Omega}$ is chosen as a first point, corresponding to the first point of the cathode charge transfer arc,
- if the charge transfer anodic arc is present, the first point is chosen among the filtered sampled data as the last one belonging to the anodic charge transfer arc, wherein the information about how many sampled measured points belong to each arc is obtained in sub-step H.9 through the Bode plot considering the inflection points,
- if the diffusion arc is not present, the second point is chosen as a second interception of the measured impedance spectrum $Z'$ with the real axis,
- if the diffusion arc is present, the second point is chosen in the range of an inflection point, optionally three or four points before the inflection point,
- the third point is chosen as a mean point among the first and the second points,
- a circumference is achieved by interpolation of said three points, and coordinates of its centre and of its first and second intercepts with the real axis are computed, whereby if the anodic arc is not present the first intercept corresponds to the first point,

H.12 if the anodic charge transfer arc is present, computing (206) anode parameters so that an anodic charge transfer resistance $R_{ct,a}$ is computed as a difference between the first intercept of said circumference and the value obtained for resistance $R_{\Omega}$, and a capacitor $C_{dl}$ is computed as follows:

$$C_{dl} = \frac{1}{R_{ct,a}\omega_A} \qquad [Eq.4]$$

where $\omega_A$ is a radial frequency of a maximum negative imaginary part of the anode arc, whereby it is the point with real part equal to $(R_{\Omega} + R_{ct,a}/2)$,

H.13 computing (207) cathode parameters so that a cathode charge transfer resistance $R_{ct,c}$ is obtained as a difference between the second intercept and the first intercept, and an element *CPE* (25) representing a Constant Phase Element is **characterised by** considering an equivalent capacitor as follows:

$$C_{eq,c} = \frac{1}{R_{ct,c}\omega_C} \qquad \text{[Eq.5]}$$

where $\omega_C$ is a radial frequency of a maximum negative imaginary part of the cathode arc, assumed as the radial frequency corresponding to the point with real part equal to $(R_\Omega + R_{ct,a} + R_{ct,c}/2)$, whereby the element *CPE* can be modelled through two parameters, Q and $\phi$, as follows:

$$Z_{CPE} = \frac{1}{Q(j\omega)^\phi} \qquad \text{[Eq.6]}$$

$$Q = C_{eq,c}\omega_C^{1-\phi} \qquad \text{[Eq.7]}$$

$$\phi = 1 - \frac{2\alpha}{\pi} \qquad \text{[Eq.8]}$$

where $\alpha$ is an angle defined by the real axis and a radius of the cathode charge transfer arc,

H.14 if the diffusion arc is present, computing a Warburg element *Zw* as depending on parameters $R_d$ and $\tau_d$ as follows:

$$Z_W = R_d \frac{tanh(\sqrt{j\omega\tau_d})}{\sqrt{j\omega\tau_d}} \qquad \text{[Eq.9]}$$

where diffusion resistance $R_d$ is computed as a difference between the second intercept of the Bode plot of the measured impedance spectrum Z' with the real axis and the second intercept of said circumference with the real axis, whereby Warburg time constant $\tau_d$ is equal to

$$\tau_d = \omega_D^{-0.5} \qquad \text{[Eq.10]}$$

where $\omega_D$ is a radial frequency related to a maximum negative imaginary part of the diffusion arc, corresponding to the point with real part equal to

$$(R_\Omega + R_{ct,a} + R_{ct,c} + R_d/2),$$

H.15 outputting vector $\beta = [R_\Omega, R_{ct,a}, C_{dl}, R_{ct,c}, Q, \phi, Rd, \tau_d]$ to sub-step H.3, optionally saving vector $\beta$ in a file.

8. Method according to any one of preceding claims, wherein the first residual vector *I* is computed in step E through a matrix 2-norm of the measured impedance spectrum Z' and the EIS spectrum $Z_s$ of the Randles equivalent circuit model (ECM) having the determined parameters $\beta_0$ as follows:

$$I = \frac{\|Z'-Z_s\|_2}{\|Z_s\|_2} \qquad \text{[Eq. 1]}$$

and the second residual indicator $I_{id}$ is computed in step I through a matrix 2-norm of the measured impedance spectrum Z' and the spectrum $Z_{id}$ corresponding to the ECM having parameters $\beta_{id}$ as follows:

$$I_{id} = \frac{\|Z' - Z_{id}\|_2}{\|Z_{id}\|_2} \qquad [Eq.2]$$

9. Method according to any one of preceding claims, wherein the vector residual indicator $I_\beta$ is computed in step L as normalized difference between the identified parameter $\beta_{id}$ and the determined parameters $\beta_0$ as follows:

$$I_\beta = \frac{\beta_{id} - \beta_0}{\beta_0} \qquad [Eq.3]$$

10. Method according to any one of preceding claims, wherein the electrochemical device comprises a polymer electrolyte fuel cell (PEFC) system.

11. Apparatus for determining the state of an electrochemical device comprising an electrochemical impedance spectroscopy (EIS) device and processing means configured to execute the method for determining the state of an electrochemical device according to any one of claims 1 to 10.

**Patentansprüche**

1. Verfahren zur Bestimmung des Zustands einer elektrochemischen Vorrichtung auf der Grundlage einer automatischen
elektrochemische Impedanzidentifizierung, wobei das Verfahren die folgenden Schritte umfasst:

A. Messung (101) der Betriebsbedingungen des elektrochemischen Geräts und Sammlung von Informationen;
B. Bestimmung (102) der Parameter ßo, eines Randles-Ersatzschaltbildes (ECM) auf der Grundlage der gemessenen Betriebsbedingungen;
C. Messung (103) des Impedanzspektrums $Z'$ der elektrochemischen Vorrichtung mit einem Gerät für elektrochemische Impedanzspektroskopie (EIS);
D. Simulieren (104) eines EIS-Spektrums $Z_s$ der Randles-ECM mit den ermittelten Parametern ßo;
E. Berechnung (105) eines ersten Restindikators $I$, der eine Differenz zwischen dem gemessenen Impedanzspektrum $Z'$ und dem simulierten EIS-Spektrum $Z_s$ der Randles-ECM angibt;
F. Prüfung (106), ob der erste Restvektor $I$ größer als ein erster vorbestimmter Schwellenwert $\varepsilon_1$ ist;
G. wenn der Restindikator $I$ niedriger als der erste vorbestimmte Schwellenwert $\varepsilon_1$ ist, erkennen, dass sich die elektrochemische Vorrichtung in einem normalen Betriebszustand befindet, und die Ausführung des Verfahrens beenden;
H. wenn der Restindikator $I$ größer als der erste vorbestimmte Schwellenwert $\varepsilon_1$ ist, Starten (108) eines automatischen Identifizierungsverfahrens zum Identifizieren eines Satzes von Parametern $\beta_{id}$, die mit dem tatsächlichen Betriebszustand der elektrochemischen Vorrichtung und einem Spektrum $Z_{id}$, das einem ECM mit Parametern $\beta_{id}$ entspricht, wobei das automatische Identifizierungsverfahren auf einem Geometrical First Guess (GFG)-Algorithmus basiert, der einen mathematischen Minimierungsalgorithmus durchführt, der eine Anzahl von zu identifizierenden Parametern definiert, wodurch die ECM-Komponenten identifiziert werden, und Startwerte dieser zu identifizierenden Parameter, wobei der GFG automatisch ein ECM erkennt und den Startparameter-Suchraum durch eine geometrische Voranalyse der Form des gemessenen Impedanzspektrums $Z'$ auswählt;
I. Berechnung (109) eines zweiten Restindikators $I_{id}$, der eine Differenz zwischen dem gemessenen Impedanzspektrum $Z'$ und dem Spektrum $Z_{id}$ anzeigt, das der ECM mit den Parametern $\beta_{id}$ entspricht;
J. Prüfung (110), ob der zweite Restindikator größer als ein zweiter vorbestimmter Schwellenwert $\varepsilon_2$ ist;
K. wenn der Restindikator $I$ größer als der zweite vorbestimmte Schwellenwer $\varepsilon_2$ ist, erkennen, dass die Ausführung des Verfahrens durch Rauschen beeinträchtigt sein könnte, und erzeugen einer Warnmeldung (111);
L. Berechnung (112) eines Vektor-Residualindikators $I_\beta$, der einen Satz von Residuen enthält, die eine Differenz zwischen den identifizierten Parametern $\beta_{id}$ und den ermittelten Parametern $\beta_0$ anzeigen;
M. Prüfung (113), ob der Vektor-Restindikator $I_\beta$ größer ist als eine Reihe spezifischer Schwellenwerte $\varepsilon_3$, die jeweils einem bestimmten Parameter zugeordnet sind;
N. wenn alle Residuen des Vektor-Residuen-Indikators $I_\beta$ niedriger sind als die jeweiligen Schwellenwerte des Satzes $\varepsilon_3$, Erkennen (114), dass die elektrochemische Vorrichtung sich in der Nähe eines normalen Betriebszustands befindet, wodurch erkannt wird, dass kein Fehler in der elektrochemischen Vorrichtung auftritt, und Beenden der Ausführung des Verfahrens;

O. wenn mindestens einer der Residuen des Vektor-Restindikators $I_\beta$ größer als der jeweilige Schwellenwert des Satzes $\varepsilon_3$ ist, Abgleichen (115) von Symptomen, die variable Abweichungen von den normalen Bedingungen darstellen, mit den gesammelten Informationen in einer Fehler-Symptom-Matrix (FSM); und

P. Ableitung (116) des Betriebszustands der elektrochemischen Vorrichtung auf der Grundlage des FSM, wobei mindestens ein bestimmter Fehler in der elektrochemischen Vorrichtung isoliert wird.

2. Verfahren nach Anspruch 1, wobei Schritt H eine automatische Identifizierung (108) startet Das Verfahren zur Identifizierung eines Satzes von Parametern $\beta_{id}$, die sich auf den tatsächlichen Betriebszustand der elektrochemischen Vorrichtung beziehen, und eines Spektrums $Z_{id}$, das einer ECM mit Parametern $\beta_{id}$ entspricht, umfassend die folgenden Teilschritte:

H.1 Abtastung (32) der in Schritt C gemessenen Daten, wobei die Punkte mit Imaginärteil gefiltert werden die positiv oder nahe Null sind, werden gefiltert,

H.2 Eingabe (33) der gefilterten Abtastdaten in den Geometrical First Guess (GFG)-Algorithmus,

H.3 Eingabe (34) der gefilterten Abtastdaten, der identifizierten ECM-Komponenten und der identifizierten Ausgangswerte der zu identifizierenden Parameter in einen auf einem Optimierungsalgorithmus (35) basierenden Minimierungsalgorithmus,

H.4 Berechnung (36) der Anpassungsgüte des der ECM mit den Parametern $\beta_{id}$ entsprechenden Spektrums $Z_{id}$ an das gemessene Impedanzspektrum $Z'$,

H.5 Prüfung (37), ob die Anpassungsgüte in Bezug auf einen festen Referenzwert ausreichend ist,

H.6 wenn die Anpassungsgüte ausreichend ist, wird mit Schritt I fortgefahren,

H.7 wenn die Anpassungsgüte nicht ausreicht, Änderung der Ausgangswerte der zu ermittelnden Parameter und Rückkehr zu Teilschritt H.3.

3. Verfahren nach Anspruch 2, wobei in Unterschritt H.3 der Minimierungsalgorithmus ein nichtlinearer Anpassungsalgorithmus, optional ein komplexer nichtlinearer Least Square (CNLS), und/oder der Optimierungsalgorithmus ein Nelder-Mead-Algorithmus ist.

4. Verfahren nach Anspruch 2 oder 3, wobei in Unterschritt H.4 die Anpassungsgüte durch eine Größe berechnet wird, die aus der Gruppe ausgewählt wird, die eine Matrix-2-Norm, die der prozentualen Abweichung des Spektrums $Z_{id}$ in Bezug auf das gemessene Impedanzspektrum $Z'$ entspricht, und einen X-Quadrat-Koeffizienten umfasst, wobei in Unterschritt H.5 diese Größe mit dem festen Referenzwert verglichen wird.

5. Verfahren nach einem der Ansprüche 2 bis 4, wobei in Schritt H.6 die ECM mit den Parametern $\beta_{id}$ und gegebenenfalls das entsprechende Spektrum $Z_{id}$ in einer Datei gespeichert (38) werden.

6. Verfahren nach einem der Ansprüche 2 bis 5, wobei im Teilschritt H.7 die Startwerte der zu identifizierenden Parameter innerhalb des Suchraumes zufällig so verändert werden, dass die neuen Parameter-Startwerte die gleiche Größenordnung wie die alten Parameter-Startwerte behalten.

7. Verfahren nach einem der Ansprüche 2 bis 6, wobei der GFG-Algorithmus in Schritt H die folgenden Teilschritte umfasst:

H.8 Identifizierung (201) eines Maximalwerts der negativen Phase in einem Bode-Diagramm des gemessenen Impedanzspektrums $Z'$, der die hohen Frequenzen von den mittleren/niedrigen Frequenzen trennt, und Charakterisierung des Bode-Diagramms durch Verwendung polynomialer Regressionskurven,

H.9 Auswerten (202) der Ableitungen der polynomialen Regressionskurven in Bezug auf die radialen Frequenzen, wodurch die anodischen und/oder Diffusionsbögen des Bode-Plots erfasst werden, so dass alle Wendepunkte identifiziert werden und somit die Anzahl der Bögen festgelegt wird,

H.10 Einstellung (203) eines Widerstandes $R_\Omega$, der als Schnittpunkt eines ersten Linksbogens des gemessenen Impedanzspektrums $Z'$ mit der reellen Achse in der Nyquist-Ebene extrapoliert wird,

H.11 Auswerten (204) eines Kathoden-Ladungstransferbogens durch Auswählen von drei Punkten unter denen, die zwischen dem anodischen Ladungstransferbogen und dem Diffusionsbogen des Bode-Diagramms liegen, entsprechend einer Anzahl von Bögen, die in dem Bode-Diagramm vorhanden sind, wobei:

- wenn der anodische Ladungsübertragungsbogen nicht vorhanden ist, wird ein Punkt mit einem Imaginärteil von Null und einem Realteil gleich $R_\Omega$ als erster Punkt gewählt, der dem ersten Punkt des kathodischen Ladungsübertragungsbogens entspricht,

- wenn der anodische Ladungstransferbogen vorhanden ist, wird der erste Punkt unter den gefilterten Abtastdaten als der letzte Punkt ausgewählt, der zum anodischen Ladungstransferbogen gehört, wobei die Information, wie viele abgetastete Messpunkte zu jedem Bogen gehören, in Teilschritt H.9 durch den Bode-Plot unter Berücksichtigung der Wendepunkte gewonnen wird,

- wenn der Diffusionsbogen nicht vorhanden ist, wird der zweite Punkt als zweiter Schnittpunkt des gemessenen Impedanzspektrums $Z'$ mit der realen Achse gewählt,

- wenn der Diffusionsbogen vorhanden ist, wird der zweite Punkt im Bereich eines Wendepunktes gewählt, optional drei oder vier Punkte vor dem Wendepunkt,

- der dritte Punkt wird als Mittelwert zwischen dem ersten und dem zweiten Punkt gewählt,

- ein Umfang durch Interpolation der drei Punkte erhalten wird und die Koordinaten seines Mittelpunkts und seines ersten und zweiten Schnittpunkts mit der realen Achse berechnet werden, wobei, wenn der anodische Bogen nicht vorhanden ist, der erste Schnittpunkt dem ersten Punkt entspricht,

H.12 wenn der anodische Ladungsübertragungsbogen vorhanden ist, Berechnen (206) von Anodenparametern, so dass ein anodischer Ladungsübertragungswiderstand $R_{ct,\,a}$ als Differenz zwischen dem ersten Schnittpunkt des genannten Umfangs und dem für den Widerstand $R_\Omega$ erhaltenen Wert berechnet wird, und ein Kondensator $C_{dl}$ wie folgt berechnet wird:

$$C_{dl} = \frac{1}{R_{ct,a}\omega_A} \qquad [\text{Eq.4}]$$

wobei eine radiale Frequenz eines maximalen negativen Imaginärteils des Anodenbogens ist $\omega_A$, wobei es sich um den Punkt mit dem Realteil gleich ($R_\Omega + R_{ct,a}/2$) handelt,

H.13 Berechnung (207) von Kathodenparametern, so dass ein Kathoden-Ladungsübergangswiderstand $R_{ct,c}$ als Differenz zwischen dem zweiten Schnittpunkt und dem ersten Schnittpunkt erhalten wird, und ein Element $CPE$ (25), das ein Konstantphasenelement darstellt, wird durch die Berücksichtigung eines äquivalenten Kondensators wie folgt charakterisiert:

$$C_{eq,c} = \frac{1}{R_{ct,c}\omega_C} \qquad [\text{Eq.5}]$$

wobei die $\omega_C$ Radialfrequenz des maximalen negativen Imaginärteils des Kathodenbogens als die Radialfrequenz angenommen wird, die dem Punkt entspricht, dessen Realteil gleich ($R_\Omega + R_{ct,a} + R_{ct,c}/2$) ist, wobei das Element $CPE$ durch zwei Parameter, Q und $\Phi$, wie folgt modelliert werden kann:

$$Z_{CPE} = \frac{1}{Q(j\omega)^\phi} \qquad [\text{Eq.6}]$$

$$Q = C_{eq,c}\omega_C^{1-\phi} \qquad [\text{Eq.7}]$$

$$\phi = 1 - \frac{2\alpha}{\pi} \qquad [\text{Eq.8}]$$

wobei der Winkel $\alpha$ durch die reelle Achse und den Radius des Kathodenladungsübertragungsbogens definiert ist,

H.14 wenn der Diffusionsbogen vorhanden ist, Berechnung eines Warburg-Elements $Z_W$ in Abhängigkeit von den Parametern $R_d$ und $\tau_d$ wie folgt:

$$Z_W = R_d \frac{tanh(\sqrt{j\omega\tau_d})}{\sqrt{j\omega\tau_d}} \qquad [\text{Eq.9}]$$

wobei der Diffusionswiderstand $R_d$ als Differenz zwischen dem zweiten Schnittpunkt des Bode-Diagramms des gemessenen Impedanzspektrums Z' mit der realen Achse und dem zweiten Schnittpunkt des genannten Umfangs mit der realen Achse berechnet wird, wobei die Warburg-Zeitkonstante $\tau_d$ gleich

$$\tau_d = \omega_D^{-0.5} \qquad [Eq.10]$$

wobei $\omega_D$ eine Radialfrequenz ist, die mit dem maximalen negativen Imaginärteil des Diffusionsbogen, der dem Punkt entspricht, dessen Realteil gleich

$$(R_\Omega + R_{ct,a} + R_{ct,c} + R_d/2),$$

H.15 Ausgabe an $\beta = [R_\Omega, R_{ct,a}, C_{dl}, R_{ct,c}, Q, \phi, R_d, \tau_d]$ Teilschritt H.3, optional Speichern des Vektors β in einer Datei.

8. Verfahren nach einem der vorhergehenden Ansprüche, wobei der erste Restvektor / in Schritt E durch eine 2-Norm-Matrix des gemessenen Impedanzspektrums Z' und des EIS-Spektrums $Z_s$ des Randles-Ersatzschaltungsmodells (ECM) mit den bestimmten Parametern wie $\beta_0$ folgt berechnet wird:

$$I = \frac{\|Z' - Z_s\|_2}{\|Z_s\|_2} \qquad [Eq.\ 1]$$

und der zweite Restindikator $I_{id}$ wird in Schritt I durch eine 2-Norm-Matrix des gemessenen Impedanzspektrums Z' und des Spektrums $Z_{id}$ berechnet, das der ECM mit den folgenden Parametern $\beta_{id}$ entspricht:

$$I_{id} = \frac{\|Z' - Z_{id}\|_2}{\|Z_{id}\|_2} \qquad [Eq.2]$$

9. Verfahren nach einem der vorhergehenden Ansprüche, wobei der Vektor-Restindikator $I_\beta$ in Schritt L als normalisierte Differenz zwischen dem identifizierten Parameter $\beta_{id}$ und den ermittelten Parametern wie $\beta_0$ folgt berechnet wird:

$$I_\beta = \frac{\beta_{id} - \beta_0}{\beta_0} \qquad [Eq.3]$$

10. Verfahren nach einem der vorhergehenden Ansprüche, wobei die elektrochemische Vorrichtung ein Polymerelektrolyt-Brennstoffzellensystem (PEFC) umfasst.

11. Vorrichtung zur Bestimmung des Zustands einer elektrochemischen Vorrichtung, die eine elektrochemische Impedanzspektroskopie (EIS)-Vorrichtung und Verarbeitungsmittel umfasst, die so konfiguriert sind, dass sie das Verfahren zur Bestimmung des Zustands einer elektrochemischen Vorrichtung nach einem der Ansprüche 1 bis 10 ausführen.

## Revendications

1. Procédé de détermination de l'état d'un dispositif électrochimique basé sur une identification automatique d'impédance électrochimique, le procédé comprenant les étapes suivantes :

A. mesurer (101) les conditions de fonctionnement du dispositif électrochimique en recueillant des informations ;
B. déterminer (102) les paramètres $\beta_0$, d'un modèle de circuit équivalent (ECM) de Randles à partir des conditions de fonctionnement mesurées ;
C. mesurer (103) le spectre d'impédance Z' du dispositif électrochimique avec un dispositif de spectroscopie d'impédance électrochimique (EIS) ;
D. simuler (104) un spectre EIS $Z_s$, de l'ECM de Randles ayant les paramètres déterminés $\beta_0$ ;

E. calculer (105) un premier indicateur résiduel *I* indiquant une différence entre le spectre d'impédance mesuré Z' et le spectre EIS simulé $Z_s$ de l'ECM de Randles ;

F. vérifier (106) si le premier vecteur résiduel *I* est supérieur à un premier seuil prédéterminé $\varepsilon_1$ ;

G. si l'indicateur résiduel *I* est inférieur au premier seuil prédéterminé $\varepsilon_1$, reconnaître que le dispositif électrochimique est dans un état de fonctionnement normal et terminer l'exécution du procédé ;

H. si l'indicateur résiduel *I* est supérieur au premier seuil prédéterminé $\varepsilon_1$, démarrer (108) une procédure d'identification automatique pour identifier un ensemble de paramètres $\beta_{id}$ liés à l'état de fonctionnement réel du dispositif électrochimique et un spectre $Z_{id}$ correspondant à un ECM ayant des paramètres $\beta_{id}$, où la procédure d'identification automatique est basée sur un algorithme de Première Estimation Géométrique (GFG) effectuant un algorithme de minimisation mathématique définissant un certain nombre de paramètres à identifier, de sorte que les composants ECM sont identifiés, et des valeurs de démarrage de ces paramètres devant être identifiés, de façon que la GFG détecte automatiquement un ECM et sélectionne l'espace de recherche des paramètres de démarrage grâce à une préanalyse géométrique de la forme du spectre d'impédance mesuré Z' ;

I. calculer (109) un deuxième indicateur résiduel $I_{id}$ indiquant une différence entre le spectre d'impédance mesuré Z' et le spectre $Z_{id}$ correspondant à l'ECM ayant des paramètres $\beta_{id}$ ;

J. vérifier (110) si le deuxième indicateur résiduel $I_{id}$ est supérieur à un deuxième seuil prédéterminé $\varepsilon_2$ ;

K. si l'indicateur résiduel *I* est supérieur au second seuil prédéterminé $\varepsilon_2$, reconnaître que l'exécution du procédé peut être affectée par du bruit et générer (111) une alerte ;

L. calculer (112) un vecteur indicateur résiduel $I_\beta$, comprenant un ensemble de résidus, indiquant une différence entre les paramètres identifiés $\beta_{id}$ et les paramètres déterminés $\beta_0$ ;

M. vérifier (113) si le vecteur indicateur résiduel $I_\beta$ est supérieur à un ensemble de seuils spécifiques $\varepsilon_3$, associés chacun à un paramètre respectif ;

N. si tous les résidus du vecteur indicateur résiduel $I_\beta$ sont inférieurs aux seuils respectifs de l'ensemble $\varepsilon_3$, reconnaître (114) que le dispositif électrochimique est proche d'un état de fonctionnement normal, de sorte qu'il est reconnu qu'aucun défaut ne se produit dans le dispositif électrochimique, et terminer l'exécution du procédé ;

O. si au moins un des résidus de l'indicateur résiduel vectoriel $I_\beta$ est supérieur au seuil respectif de l'ensemble $\varepsilon_3$, faire correspondre (115) des symptômes représentant des écarts variables par rapport aux conditions normales avec les informations recueillies dans une Matrice des Défauts aux Symptômes (FSM) ; et

P. déduire (116) l'état de fonctionnement du dispositif électrochimique sur la base du FSM, de sorte qu'au moins un défaut spécifique se produisant dans le dispositif électrochimique est isolé.

2. Procédé selon la revendication 1, dans lequel l'étape H de démarrage (108) d'une procédure d'identification automatique pour identifier un ensemble de paramètres $\beta_{id}$ liés à l'état de fonctionnement réel du dispositif électrochimique et un spectre $Z_{id}$ correspondant à un ECM ayant des paramètres $\beta_{id}$ comprend ce qui les sous-étapes suivantes :

H.1 échantillonner (32) des données mesurées à l'étape C, de sorte que les points dont la partie imaginaire est positive ou proche de zéro sont filtrés,

H.2 entrer (33) les données échantillonnées filtrées dans l'algorithme de Première Estimation Géométrique (GFG),

H.3 entrer (34) les données échantillonnées filtrées, les composants ECM identifiés et les valeurs de démarrage identifiées des paramètres à identifier dans un algorithme de minimisation basé sur un algorithme d'optimisation (35),

H.4 calculer (36) une qualité d'ajustement du spectre $Z_{id}$ correspondant à l'ECM ayant des paramètres $\beta_{id}$ au spectre d'impédance mesuré Z',

H.5 vérifier (37) si la qualité d'ajustement est suffisante par rapport à une valeur de référence fixée,

H.6 si la qualité d'ajustement est suffisante, passer à exécuter l'étape I,

H.7 si la qualité d'ajustement n'est pas suffisante, modifier les valeurs de démarrage des paramètres à identifier et revenir à la sous-étape H.3.

3. Procédé selon la revendication 2, dans lequel à la sous-étape H.3 l'algorithme de minimisation est un algorithme à Ajustement Non Linéaire, optionnellement un Moindre Carré Complexe Non-Linéaire (CNLS), et/ou l'algorithme d'optimisation est un algorithme de Nelder-Mead .

4. Procédé selon la revendication 2 ou 3, dans lequel à la sous-étape H.4 la qualité d'ajustement est calculée via une quantité choisie dans le groupe comprenant une matrice de norme 2 correspondant au pourcentage de variation du spectre $Z_{id}$ par rapport au spectre d'impédance mesuré Z' et un coefficient à carré X, de sorte qu'à la sous-étape H.5 ladite quantité est comparée à la valeur de référence fixe.

**5.** Procédé selon l'une quelconque des revendications 2 à 4, dans lequel à l'étape H.6 l'ECM ayant les paramètres $\beta_{id}$, et optionnellement le spectre correspondant $Z_{id}$, sont enregistrés (38) dans un fichier.

**6.** Procédé selon l'une quelconque des revendications 2 à 5, dans lequel à la sous-étape H.7 les valeurs de démarrage des paramètres à identifier sont modifiées aléatoirement au sein de l'espace de recherche de sorte que les nouvelles valeurs de démarrage des paramètres conservent les mêmes ordres de grandeur des anciennes valeurs de démarrage des paramètres.

**7.** Procédé selon l'une quelconque des revendications 2 à 6, dans lequel l'algorithme GFG à l'étape H comprend les sous-étapes suivantes :

H.8 identifier (201), dans un diagramme de Bode du spectre d'impédance mesuré Z', une valeur maximale de phase négative qui sépare les hautes fréquences des moyennes/basses fréquences, et caractériser le diagramme de Bode en utilisant des courbes de régression polynomiale,
H.9 évaluer (202) les dérivées desdites courbes de régression polynomiale par rapport aux fréquences radiales, de façon que les arcs anodiques et/ou de diffusion du diagramme de Bode sont détectés, de sorte que tous les points d'inflexion sont identifiés et ainsi que le nombre d'arcs soit fixé,
H.10 définir (203) une résistance $R_\Omega$ qui est extrapolée comme l'intersection d'un premier arc du côté gauche du spectre d'impédance mesuré Z' avec l'axe réel dans le plan de Nyquist,
H.11 évaluer (204) un arc de transfert de charge cathodique en sélectionnant trois points parmi ceux situés entre l'arc de transfert de charge anodique et l'arc de diffusion du diagramme de Bode selon un certain nombre d'arcs présents dans le diagramme de Bode, où :

- si l'arc de transfert de charge anodique n'est pas présent, un point de partie imaginaire nulle et de partie réelle égale à $R_\Omega$ est choisi comme premier point, correspondant au premier point de l'arc de transfert de charge cathodique,
- si l'arc anodique à transfert de charge est présent, le premier point est choisi parmi les données échantillonnées filtrées comme le dernier appartenant à l'arc à transfert de charge anodique, où les informations sur le nombre de points mesurés échantillonnés appartenant à chaque arc sont obtenues à la sous-étape H.9 via le diagramme de Bode en considérant les points d'inflexion,
- si l'arc de diffusion n'est pas présent, le second point est choisi comme seconde intersection du spectre d'impédance mesuré Z' avec l'axe réel,
- si l'arc de diffusion est présent, le deuxième point est choisi dans l'intervalle d'un point d'inflexion, optionnellement trois ou quatre points avant le point d'inflexion,
- le troisième point est choisi comme point moyen entre le premier et le deuxième point,
- une circonférence est obtenue par interpolation desdits trois points, et les coordonnées de son centre et de ses première et deuxième intersections avec l'axe réel sont calculées, de sorte que si l'arc anodique n'est pas présent, la première intersection correspond au premier point,

H.12 si l'arc de transfert de charge anodique est présent, calculer (206) des paramètres d'anode de sorte qu'une résistance de transfert de charge anodique $R_{ct,a}$ soit calculée comme une différence entre la première intersection de ladite circonférence et la valeur obtenue pour la résistance $R_\Omega$ et un condensateur $C_{dl}$ se calcule comme suit :

$$C_{dl} = \frac{1}{R_{ct,a}\omega_A} \qquad [Eq.4]$$

où $\omega_A$ est une fréquence radiale d'une partie imaginaire négative maximale de l'arc anodique, c'est-à-dire le point dont la partie réelle est égale à $(R_\Omega + R_{ct,a}/2)$,
H.13 calculer (207) des paramètres de cathode de telle sorte qu'une résistance de transfert de charge cathodique $R_{ct,c}$ soit obtenue comme une différence entre la seconde intersection et la première intersection, et un élément *CPE* (25) représentant un Elément à Phase Constante est caractérisé en considérant un condensateur équivalent comme suit :

$$C_{eq,c} = \frac{1}{R_{ct,c}\omega_C} \qquad [Eq.5]$$

où $\omega_C$ est une fréquence radiale d'une partie imaginaire négative maximale de l'arc cathodique, supposée être la fréquence radiale correspondant au point de partie réelle égale à $(R_\Omega + Rct,a + Rct,c/2)$, où l'élément CPE peut être modélisé à travers deux paramètres, $Q$ et $\phi$, comme suit :

$$Z_{CPE} = \frac{1}{Q(j\omega)^\phi} \qquad [\text{Eq.6}]$$

$$Q = C_{eq,c}\,\omega_C^{1-\phi} \qquad [\text{Eq.7}]$$

$$\phi = 1 - \frac{2\alpha}{\pi} \qquad [\text{Eq.8}]$$

où $\alpha$ est un angle défini par l'axe réel et un rayon de l'arc de transfert de charge cathodique,
H.14 si l'arc de diffusion est présent, calculer un élément de Warburg $Z_W$ en fonction de paramètres $R_d$ et $\tau_d$ comme suit :

$$Z_W = R_d \frac{tanh(\sqrt{j\omega\tau_d})}{\sqrt{j\omega\tau_d}} \qquad [\text{Eq.9}]$$

où la résistance de diffusion $R_d$ est calculée comme une différence entre la deuxième intersection du diagramme de Bode du spectre d'impédance mesuré Z' avec l'axe réel et la deuxième intersection de ladite circonférence avec l'axe réel, la constante de temps de Warburg $\tau_d$ étant égale à

$$\tau_d = \omega_D^{-0.5} \qquad [\text{Eq.10}]$$

où $\omega_D$ est une fréquence radiale liée à une partie imaginaire négative maximale de l'arc de diffusion, correspondant au point de partie réelle égale à

$$(R_\Omega + R_{ct,a} + R_{ct,c} + R_d/2),$$

H.15 produire un vecteur $\beta = [R_\Omega, R_{ct,a,}, C_{dl}, R_{ct,c}, Q, \phi, R_d, \tau_d]$ à la sous-étape H.3, en sauvegardant optionnellement le vecteur $\beta$ dans un fichier.

8. Procédé selon l'une quelconque des revendications précédentes, dans lequel le premier vecteur résiduel *I* est calculé à l'étape E à travers une matrice de norme 2 du spectre d'impédance mesuré Z' et du spectre EIS $Z_s$, du modèle de circuit équivalent (ECM) de Randles ayant les paramètres déterminés $\beta_0$ comme suit :

$$I = \frac{\|Z'-Z_s\|_2}{\|Z_s\|_2} \qquad [\text{Eq. 1}]$$

et le deuxième indicateur résiduel $I_{id}$ est calculé à l'étape I via une matrice de norme 2 du spectre d'impédance mesuré Z' et du spectre $Z_{id}$ correspondant à l'ECM ayant pour paramètres $\beta_{id}$ comme suit :

$$I_{id} = \frac{\|Z'-Z_{id}\|_2}{\|Z_{id}\|_2} \qquad [\text{Eq.2}]$$

9. Procédé selon l'une quelconque des revendications précédentes, dans lequel le vecteur indicateur résiduel $I_\beta$ est calculé à l'étape L comme différence normalisée entre le paramètre identifié $\beta_{id}$ et les paramètres déterminés $\beta_0$

comme suit :

$$I_\beta = \frac{\beta_{id} - \beta_0}{\beta_0} \qquad\qquad [\text{Eq.3}]$$

10. Procédé selon l'une quelconque des revendications précédentes, dans lequel le dispositif électrochimique comprend un système de pile à combustible à électrolyte polymère (PEFC).

11. Appareil de détermination de l'état d'un dispositif électrochimique comprenant un dispositif de spectroscopie d'impédance électrochimique (EIS) et des moyens de traitement configurés pour exécuter le procédé de détermination de l'état d'un dispositif électrochimique selon l'une quelconque des revendications 1 à 10.

**FIG. 1**

**FIG. 2A**

**FIG. 2B**

FIG. 3

FIG. 4

$3\tau\ ECM - 3$ Arcs {c.t./dif.}

**FIG. 5A**

$2\tau\ ECM - 2$ Arcs {c.t.}

**FIG. 5B**

$2\tau\ ECM - 2$ Arcs {c.t. / dif.}

**FIG. 5C**

$1\tau\ ECM - 1$ Arc {c.t.}

**FIG. 5D**

**FIG. 6**

FIG. 7

FIG. 8

FIG. 9

**EP 3 215 832 B1**

**REFERENCES CITED IN THE DESCRIPTION**

**Patent documents cited in the description**

- US 2003061182 A1
- US 2008042654 A1
- US 2009169934 A1
- US 20050287402 A1
- US 20100286939 A1
- US 20070172708 A1
- US 2003184307 A1

**Non-patent literature cited in the description**

- **PAPER OF R. PETRONE et al.** A review on model-based diagnosis methodologies for PEMFCs. *International Journal of Hydrogen Energy,* 25 April 2013, vol. 38 (17), 7077-7091
- **FOUQUET et al.** *J. Power Sources,* 2006, vol. 159, 905-913